**Europäisches Patentamt**

**European Patent Office**

**Office européen des brevets**

(19)

(11) Veröffentlichungsnummer : **0 116 350**
**B1**

(12) ## EUROPÄISCHE PATENTSCHRIFT

(45) Veröffentlichungstag der Patentschrift :
09.09.87

(51) Int. Cl.⁴ : **H 03 J   3/32**

(21) Anmeldenummer : **84101096.0**

(22) Anmeldetag : **03.02.84**

(54) **Abstimmeinheit für Geräte der Nachrichtentechnik.**

(30) Priorität : 04.02.83 DE 3303711

(43) Veröffentlichungstag der Anmeldung :
22.08.84 Patentblatt 84/34

(45) Bekanntmachung des Hinweises auf die Patenterteilung : 09.09.87 Patentblatt 87/37

(84) Benannte Vertragsstaaten :
AT BE CH DE FR GB IT LI LU NL SE

(56) Entgegenhaltungen :
DE-A- 2 854 852
FR-A- 2 513 055
US-A- 4 334 323
PATENTS ABSTRACTS OF JAPAN, Band 4, Nr. 28 (E-
1)(510), 8. März 1980
PATENTS ABSTRACTS OF JAPAN, Band 6, Nr. 103 (E-
112)(981), 12. Juni 1982

(73) Patentinhaber : Deutsche Thomson-Brandt GmbH
Hermann-Schwer-Strasse 3 Postfach 2060
D-7730 Villingen-Schwenningen (DE)

(72) Erfinder : Maier, Gerhard
Reutestrasse 19
D-7735 Dauchingen (DE)
Erfinder : Lange, Joachim
Freiburger Strasse 61
D-7730 Villingen-Schwenningen (DE)

EP 0 116 350 B1

## Beschreibung

Die Erfindung geht aus von einer Abstimmeinheit für Geräte der Nachrichtentechnik insbesondere Fernseh- und Rundfunkempfangsgeräte unter Verwendung eines PLL-Systems, welches beim Abstimmen des Empfangsgerätes nacheinander die einzelnen Abstimmkreise auf die von der PLL erzeugte Frequenz abstimmt und die auf diese Weise gewonnenen Abstimmspannungen der einzelnen Filterkreise festhält.

Eine derartige Abstimmeinheit ist z. B. in der DE-A-2 854 852 beschrieben, die mittels dreier Hilfsoszillatoren und diesen zugeordneten Analogspeichern unter Verwendung der PLL-Schaltung die Hochfrequenzkreise auf die gewünschte Empfangsfrequenz abstimmen. Es sind der Zahl der abzugleichenden Hochfrequenzkreise entsprechend Hilfsoszillatoren notwendig. Die Zahl der benötigten Hilfsoszillatoren und somit der Materialaufwand erhöht sich dann in besonderem Maße, wenn z. B. beim Abgleich eines Fernsehempfängers Band 1, Band III und die Bänder IV und V abgeglichen werden sollen. Es besteht dabei die Gefahr von Mehrdeutigkeiten zwischen den Frequenzen des Tuneroszillators, der Hilfsoszillatoren und den Empfangsfrequenzen. Nachteilig für eine praktikabel Realisierung der bekannten Abstimmeinheiten ist, daß die Erregerwicklungen der einzelnen Hilfsoszillatoren mit den einzelnen Spulen in den Hochfrequenzkreisen unerwünschte Resonanzen und Bedämpfungen der Kreise im Empfangsfalle hervorrufen können, die auch noch eine unkontrollierbare Verstimmung der Kreise verursachen, wenn die Hilfsoszillatoren nach erfolgtem Abgleich abgeschaltet werden sollen.

In der Zeitschrift « Nachrichten elektronik » Heft 11/79, Seiten 365-368 wird ein Abstimmverfahren für Rundfunkempfänger beschrieben, das ebenfalls zusätzliche Hilfskreise in den Hochfrequenzfiltern anwendet. Auch hier ergeben sich nachteilige Beeinflussungen der Kreise im Betrieb des abgeglichenen Empfängers. Wie auf Seite 367 linke und mittlere Spalte angegeben, wird die Genauigkeit der Abstimmungen durch Spezialbauteile nur in Form von exakt gepaarten Kapazitätsdioden erzielt. Auch dies erfordert einen nicht außer acht zu lassenden Aufwand, da die Kapazitätsdioden auf demselben Chip realisiert werden müssen.

In der US-A-4 334 323 wird eine elektrische Abstimmeinheit beschrieben, bei der durch schrittweise Veränderung der Abstimmspannungswerte sämtliche Kreise abgestimmt werden. Die Erzeugung der Abstimmspannungswerte erfolgt dadurch, daß jedem abzustimmenden Kreis ein Step-Generator zugeordnet ist, der jeweils von einem Rechner aktiviert wird. Es handelt sich bei der bekannten Anordnung um einen sehr aufwendigen Schaltungsaufbau.

Der Erfindung liegt die Aufgabe zugrunde, einen automatischen Selbstabgleich von Nachrichtenempfangsgeräten zu erreichen, ohne Verwendung von ausgesuchten Bauteilen und mit dem Ziel eine maximale Signalamplitude am Ausgang der abzugleichenden Empfangseinheit und eine optimale, d. h. symmetrische Filterselektion bei allen Empfangskanälen und Bereichen einzustellen ohne in die HF-Empfangseinheit einzugreifen. Diese Aufgabe wird durch die in den Patentansprüchen angegebenen Maßnahmen gelöst.

Bei der vorliegenden Anmeldung wird nur ein einziger Digital-Analogwandler für die Abstimmspannungen sämtlicher abzugleichender Filter eingesetzt, der in Verbindung mit kostengünstigen analogen Zwischenspeichern den Aufbau eines selbstabgleichenden Abstimmsystems wesentlich vereinfacht.

Nachstehend soll an einem Blockschaltbild das Wesentliche der Erfindung erläutert werden.

Mit 1 ist ein HF-Empfangsgerät bezeichnet, z. B. ein Fernsehempfangsgerät. Dieses Empfangsgerät besitzt zur Ausfilterung der Emfpangsfrequenzen Filterkreise 2,1 bis 2, n. Das Empfangsgerät besitzt eine Abstimmeinheit für Kanäle im UHF- und VHF-Frequenzbereich. Die Abstimmung erfolgt mit Hilfe von Frequenzsynthese, wobei die Oszillatorfrequenz zur Abstimmung des Geräts mit Hilfe einer PLL-Schaltung 3 erzeugt wird. Diese Schaltung zur Abstimmung eines Empfangsgerätes ist bekannt, indem durch Verändern des Teilerverhältnisses eines in der PLL-Schaltung liegenden programmierbaren Teilers sich die Pll-Schaltung auf die gewünschte Oszillatorfrequenz einstellt. Das Teilerverhältnis wird codiert über eine Kanalwahleinheit eingegeben und von einer Rechnereinheit 4 als Datenwort über die Datenleitung 5 der PLL-Schaltung 3 zugeführt. Die Erfindung bezweckt nun, daß sich das Empfangsgerät bei jedem Empfangskanal selbsttätig abgleicht. Dazu wird bei der Eingabe des Empfangskanals durch die PLL-Schaltung 3 eine Kennfrequenz K aus einem Kennfrequenzoszillator 6 oder 7 an den Eingang des Empfangsgerätes geschaltet. Dies geschieht durch Umschalten einer Schaltstufe 16 mit Hilfe eines aus der Rechnereinheit 4 entnommenen Steuersignals auf der Leitung 17, die von der Frequenz des Empfängeroszillators auf die Kennfrequenz K umschaltet. Nach einer Verstärkung in einer Stufe B gelangt diese Kennfrequenz, die der Mittenfrequenz des zu empfangenden Kanals entspricht, an die Filter 2,1 bis 2, n und an einen Schaltungspunkt 9, der z. B. der Eingang der Mischstufe 18 des Empfängers sein kann. Die an diesem Punkt vorhandene Spannung mit der Frequenz K wird mit Hilfe eines Gleichrichters 19 gleichgerichtet. Diese Gleichspannung wird mit Hilfe eines Analog-Digitalwandlers 10 in einen digitalen Wert, der der Meßspannung am Punkt 9 entspricht, umgeformt.

Der Abgleich der einzelnen Filter geschieht folgendermaßen.

Der D/A-Wandler 11 wird von der Rechnereinheit 4 mit einem digitalen Wort derart angesteuert, daß z. B. die untere Abstimmspannung auftritt. Diese untere Abstimmspannung ergibt sich z. B. aus der oberen Abstimmspannung durch Teilung durch die maximale Schrittzahl des verwendeten D/A-Wandlers. Bei einem D/A-Wandler mit 6 Bit beträgt die Schrittzahl 64. Diese untere Abstimmspannung liegt in analoger Form über den Kontakt 12,1 eines Schalters 12 zunächst an einem Zwischenspeicher 13,1 und somit am ersten abzugleichenden Filterkreis 2,1. Am Meßpunkt 9 ergibt sich eine Meßspannung, die nach Gleichrichtung durch den Gleichrichter 19 in einen digitalen Wert mit Hilfe eines A/D-Wandlers 10 umgeformt wird und in der Rechnereinheit festgehalten wird. Daraufhin wird mit Hilfe der Rechnereinheit 4 der digitale Abstimmwert um einen Schritt erhöht, der über den D/A-Wandler 10 und den Kontakt 12,1 des Schalters 12 wieder an den ersten Filterkreis 2, 1 gelangt. Diese Abstimmung ergibt einen veränderten Meßwert am Meßpunkt 9. Hat sich dieser Meßwert in positiver Richtung erhöht, erhöht die Rechnereinheit 4 den digitalen Abstimmwert um einen weiteren Schritt, so daß sich die analoge Abstimmspannung über den D/A-Wandler 11 ebenfalls erhöht solange bis der maximale Spannungswert am Punkt 9 erreicht ist. Dies ist ein Kriterium dafür, daß das erste Filter 2, 1 optimal abgeglichen ist.

Der hierzu gehörige Abstimmspannungswert wird in einer Speicheradresse eines Speichers 14 abgelegt. Über die Steuerung des Rechners 4 erfolgt nun über eine Steuerleitung 20 eine Weiterschaltung des Schalters 12 auf den Kontakt 12,2. Nun erfolgt der gleiche schrittweise Abgleich für das Filter 2,2 bis auch für dieses der optimale Abgleich vorliegt. Der ermittelte Abstimmwert wird auf der nächsten Adresse des Speichers 14 abgelegt. Dieses Verfahren wird fortgesetzt, bis das letzte Filter 2,n abgeglichen ist. Über eine Steuerleitung 15 werden die analogen Zwischenspeicher 13 zur Übernahme anliegender Daten aktiviert. Da die analogen Zwischenspeicher 13 Kurzzeitspeicher sind, werden diese über die Steuerung des Rechners zyklisch aufgefrischt und so der Abgleich des Empfängers während seines Betriebes aufrechterhalten, ohne dass die beim ersten Abgleich verwendeten Kennfrequenzen neu aktiviert werden müssen. Als analoge Zwischenspeicher eignen sich Kondensatoren oder sample-and-hold-Schaltungen, welche in der heutigen Technik sehr kostengünstig sind. Diese halten den Abstimmwert bis zum Auffrischen in ausreichender Weise, da die Kapazitätsdioden der Abstimmkreise relativ hochohmig sind. Im komplett abgeglichenen Zustand wird der Kennoszillator UHF K bzw. VHF K abgeschaltet. Der Eingang des Empfangsgerätes 1 ist dann an die Antenne 21 angeschaltet. Die Oszillatorfrequenzen UHF O bzw. VHF O liegen an der Mischstufe 18 an zur Erzeugung der weiter zu verarbeitenden Zwischenfrequenz, gebildet durch die Differenz aus der Oszillatorfrequenz und der Eingangsfrequenz.

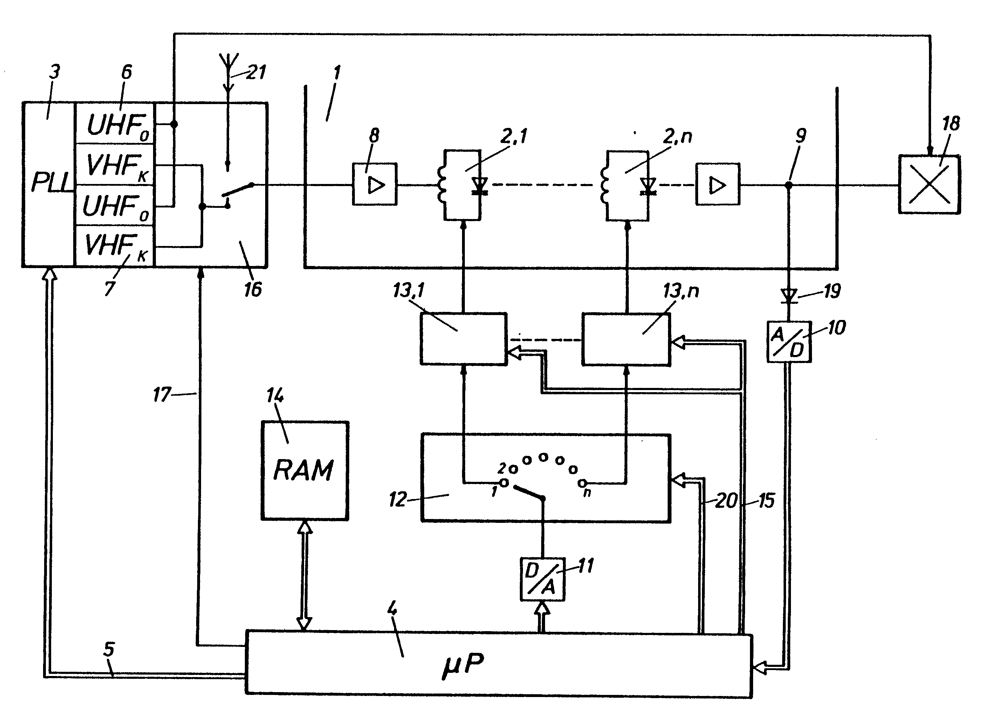

## Patentansprüche

1. Elektronische Abstimmeinheit für Geräte der Nachrichtentechnik, insbesondere Fernseh- und Rundfunkempfangsgeräte mit einem PLL(phase-locked-loop)-Abstimmsystem, bei der jedesmal bei der Anwahl eines Empfangskanals eine Kennfrequenz an den Antenneneingang geschaltet ist, die am Ausgang der HF-Filterkreise an einem Meßpunkt (9) als gleichgerichtete Spannung abgenommen und über einen Analog-Digitalwandler (10) an einen Rechner (4) geschaltet ist, der solange schrittweise einen Abstimmspannungswert erhöht, bis ein Maximalwert der Meßspannung am Meßpunkt (9) erreicht ist, wobei analoge Zwischenspeicher (13,1... 13, n) vorgesehen sind, die die Abstimmspannungen für in den Filterkreisen (2,1... 2, n) geschaltete Kapazitätsdioden liefern, dadurch gekennzeichnet, daß die einzelnen Abstimmspannungswerte über einen einzigen Digital-Analogwandler (11) und einen vom Rechner (4) gesteuerten Schalter (12) nacheinander an die Zwischenspeicher (13, x) angelegt werden, wobei vom Rechner (4) gesteuert, nach optimaler Abstimmung eines Filterkreises (2, x) der Ausgang des Digital-Analogwandlers (11) über den Schalter (12) mit dem jeweils nächstfolgenden Zwischenspeicher (13, x + 1) verbunden wird.

2. Elektronische Abstimmeinheit nach Anspruch 1, dadurch gekennzeichnet, daß in der Rechnereinheit (4) ein Speicher (14) vorgesehen ist, in welchen die digitalen Wörter für die Abstimmwerte für die einzelnen Filter (2,1 bis 2, n) abgelegt werden.

3. Elektronische Abstimmeinheit nach Anspruch 1, dadurch gekennzeichnet, daß eine zyklische Auffrischung der Zwischenspeicher (13,1 bis 13, n) erfolgt.

## Claims

1. An electronic tuning unit for communications apparatus, particularly television and radio receivers with a PLL (phase-locked-loop) tuning system, wherein every time a receiving channel is selected, a characteristic frequency is applied to the aerial input which is taken off, as a rectified voltage, at a measuring point (9) at the output of the high-frequency filter circuit and is fed, via an analogue-digital converter (10) to a computer (4) which increases a tuning-voltage value step-by-step until a maximum value of the measuring voltage at the measuring point (9) is reached, analogue intermediate stores (13,1... 13, n) being provided which deliver the tuning voltages for tuning diodes connected into the filter circuits (2,1... 2, n), characterised in that the individual tuning-voltage values are applied successively to the intermediate stores (13, x) via a single digitalanalogue converter (11) and a switch (12) controlled by the computer (4), the output of the digital-analogue converter (11) being connected, controlled by the computer (4), after optimum tuning of a filter circuit (2, x), to the following intermediate store (13, x + 1) through the switch (12).

2. An electronic tuning unit according to Claim 1, characterised in that there is provided in the computer unit (4) a store (14) in which the digital words for the tuning values for the individual filters (2,1 to 2 n) are filed.

3. An electronic tuning unit according to Claim 1, characterised in that a cyclic regeneration of the intermediate stores (13,1 to 13, n) is effected.

**Revendications**

1. Unité électronique d'accord pour des appareils du domaine technique des télécommunications, notamment des appareils récepteurs de télévision et de radio, comportant un système d'accord PLL (à boucle verrouillée en phase), dans laquelle, à chaque sélection d'un canal de réception, une fréquence caractéristique est appliquée à l'entrée d'antenne, cette fréquence étant prise à la sortie des circuits de filtrage-HF en un point de mesure (9) sous la forme d'une tension redressée et étant transmise, par l'intermédiaire d'un convertisseur analogique-numérique (10) à un calculateur (4), qui augmente de façon échelonnée la tension d'accord jusqu'à ce qu'une valeur maximale de la tension de mesure soit atteinte au point de mesure (9), des mémoires intermédiaires analogiques (13,1... 13, n) étant prévues pour appliquer les tensions d'accord à des diodes capacitives branchées dans les circuits de filtrage (2,1... 2, n), caractérisée en ce que les différentes valeurs de tension d'accord sont appliquées successivement aux mémoires intermédiaires (13, x) au moyen d'un seul convertisseur numérique-analogique (11) et d'un commutateur (12) commandé par l'unite de calcul (4), cette unité de calcul (4) faisant en sorte, après un accord optimal d'un circuit de filtrage (2, x), que la sortie du convertisseur numérique-analogique (11) soit reliée par l'intermédiaire du commutateur (12) avec la mémoire intermédiaire (13, x + 1) placée respectivement immédiatement à la suite.

2. Unité électronique d'accord selon la revendication 1, caractérisée en ce qu'il est prévu dans l'unité de calcul (4) une mémoire (14) dans laquelle sont enregistrés les mots numériques correspondant aux valeurs d'accord des différents filtres (2,1 à 2, n).

3. Unité électronique d'accord selon la revendication 1, caractérisée en ce qu'une initialisation cyclique des mémoires intermédiaires (13,1 à 13, n) est effectuée.

0 116 350